(19) Europäisches Patentamt
European Patent Office
Office européen des brevets

(11) EP 0 411 829 B1

(12) EUROPEAN PATENT SPECIFICATION

(45) Date of publication and mention of the grant of the patent: **07.02.1996 Bulletin 1996/06**

(51) Int Cl.[6]: **G11B 20/18**, H03M 13/00

(21) Application number: **90308193.3**

(22) Date of filing: **26.07.1990**

(54) **Sample data transmission apparatus**

Ubertragungsgerät für abgetastete Daten

Appareil de transmission de données échantillonnées

(84) Designated Contracting States: **AT DE FR GB**

(30) Priority: **29.07.1989 JP 197341/89**

(43) Date of publication of application: **06.02.1991 Bulletin 1991/06**

(73) Proprietor: **SONY CORPORATION**
**Tokyo (JP)**

(72) Inventors:
- **Lagadec, Roger**
  **Shinagawa-ku, Tokyo (JP)**
- **Sekiguchi, Keisuke**
  **Shinagawa-ku, Tokyo (JP)**
- **Yamauchi,Hiroyuki**
  **Shinagawa-ku, Tokyo (JP)**
- **Tezuka, Masaru**
  **Shinagawa-ku, Tokyo (JP)**
- **Tobita, Satoru**
  **Shinagawa-ku, Tokyo (JP)**
- **Hara, Hiroyuji**
  **Shinagawa-ku, Tokyo (JP)**
- **Sako, Yoichiro**
  **Shinagawa-ku, Tokyo (JP)**

(74) Representative:
**Ayers, Martyn Lewis Stanley et al**
**London WC1R 5LX (GB)**

(56) References cited:
**EP-A- 0 276 809**

- **ELECTRONICS & WIRELESS WORLD, vol. 91, no. 1592, June 1985, pages 80-82; J.R. WATKINSON: "Channel code and disc format - 2. How information is organized on the disc surface"**

EP 0 411 829 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

This invention relates to a transmission apparatus for sampled digital audio data and, more particularly, to a transmission apparatus for sampled data in which the sampled data are arranged in a two-dimensional array and error correction codes are affixed in both the row direction and the column direction of the two-dimensional array before transmission of the sampled data.

When sampled data obtained by digitizing analog signals, such as audio or video signals, are recorded or transmitted, these sampled data frequently undergo scrambling or error correction coding.

Electronics and Wireless World, Vol 91, No. 1592, June 1985, p80-82 describes a convolution code format in which to reduce the chances of burst errors preventing interpolation of uncorrectable errors, adjacent odd and even samples are separated by delaying the even samples by two blocks of 24 audio bytes. Samples are then further separated by the convolution interleave.

EP-A-0,276,809 concerns a rotary head type recording apparatus and similarly discusses the use of delaying, in this case, the odd samples by 12 blocks so as to reduce the effects of burst errors.

An example of another signal processing system is the known so-called block-complete type product code system in which the sampled data to be transmitted are grouped into blocks each containing a predetermined number of samples, these blocks are arrayed in a two-dimensional matrix configuration and error correction codes are annexed for each row and each column of the matrix. This block-complete type product code system is superior to the so-called convolution code system in editing performance, and is preferred as a recording format for digital audio disks for professional use and as a format for recording video signals.

It is also known that, in the case of sampled data obtained by digitising analog signals, such as audio or video signals, the correlation between the adjacent sampled data is sufficiently high that, when an uncorrectable error occurs, a passable approximation to the missing data sample may be produced by interpolation of sampled data adjacent to the sampled data which is in error. Equally, for transmission through or recording on a medium which is subject to burst errors, a scrambling technique is used, in which adjacent data samples, that is an odd-numbered sample and an even-numbered sample, are rearranged, prior to transmission, so that they are spaced apart from each other in or on the medium in question.

Figure 1 of the accompanying drawings shows an example of the above mentioned block complete type product code format on which the precharacterising portions of the appended claims are based. In this example sampled data $S_0$, $S_1$, $S_2$, $S_3$, ... of audio signals or the like are arrayed in a two-dimensional matrix configuration, the Q parity of the C2 code system is annexed to each row and the P parity of the C1 code system is annexed to each column. The Q parity for each row is arrayed in a column region at the horizontally central position in the drawing. In the left and right different column regions, on both sides of the Q parity region, even-numbered sample data $S_0$, $S_2$ ... and odd-numbered sample data $S_1$, $S_3$, ... are respectively arranged. During signal transmission, such as for recording, the sampled data are read from the extreme left column, in the vertical direction, as indicated by an arrow C, with the vertical scanning proceeding sequentially down successive columns towards the right in the drawing.

It will be noted that, with the above mentioned block complete type product code system, in which the sampled data to be transmitted are classed into even-numbered sampled data and odd-numbered sampled data, which are arrayed at column regions different from each other in the horizontal direction of the two-dimensional data array, the error correcting capability of a row is determined by the error correction code of the row and, if an error should occur which exceeds the error correcting capability, all of the samples of the row are determined to be uncorrectable. Since the one-row sampled data thus determined to be uncorrectable are continuous data, error concealment by the above mentioned interpolation cannot be satisfactorily performed, so that dropout may result in the reproduced signal. In the case of an audio signal, for example, unpleasant noises as a result. In addition, if the change is acute, damage may be caused to associated apparatus or equipment.

For example, assuming that the C2 code (Q parity) shown in Fig. 1 has the capability of correcting four words, if five or more words are in error in one row, as a result of, for example, burst errors, error correction cannot be made, such that all of the words of the row are determined to be in error. It is noted that, since the above mentioned continuous or mutually adjacent even-and odd-numbered samples are contained in one row all words of which are determined to be in error, and these samples represent continuous data in the original signal, it becomes impossible to perform, for example, mean value interpolation.

In view of the above mentioned drawbacks of the prior art system, it is a principal object of the present invention to provide a sampled data transmission apparatus in which error correcting measures, such as mean value interpolation, can be taken even when the totality of words in a row of a two-dimensional data array are determined to be in error.

According to the present invention, there is provided an apparatus for transmitting two dimensional blocks of digital data along with error correction codes comprising

means for splitting a predetermined amount of digital data into odd-numbered data and even-numbered data and arranging the data into a block,

means responsive to a row of the block of said odd-numbered data and said even-numbered data to generate first parity codes and to arrange said first parity codes in the respective row, said means being also responsive to a column of said block of said odd-numbered data and said even-numbered data to generate second parity codes and to arrange said second parity codes in the respective column, and supplying means for columnwise supplying said digital data and said first and second parity codes in the order of column numbers, characterised in that said splitting means includes addressing means for arranging data to be in one row of said block and for arranging substantially all of the data originally adjacent said data of said one row to be in another row of said block so that the even-numbered and odd-numbered data which were adjacent one another in the original digital signal are arranged in separate rows of said block.

Thus in a sampled data transmitting apparatus according to the invention, in which the sampled data to be transmitted $S_0$, $S_1$, $S_2$, $S_3$, ... are divided into odd-numbered samples $S_1$, $S_3$, ... and even-numbered samples $S_0$, $S_2$, ... are arranged in different rows of a two-dimensional data array and in which error correction codes Q and P are generated and annexed to each row and to each column of the two-dimensional data array, respectively, for transmission, the row arraying sequence in one of the odd-numbered or even-numbered rows is caused to differ from the row arraying sequence in the other of the odd-numbered or even-numbered rows, for example, the two adjacent rows are interchanged at the odd-number side, as shown in figure 1, so that even-numbered sample data and the odd-numbered sample data contiguous to each other in the original data stream are not arranged in one and the same row.

Thus, even if all the words in a given row are determined to be in error, there exists no continuous sample data in one and the same row, so that the errors are not continuous data and hence mean value interpolation may be performed effectively.

The invention will be further described by way of non-limitative example with reference to the accompanying drawings, in which:-

Fig. 1 shows a recording format in a conventional sampled data transmitting apparatus.

Fig. 2 shows a recording format employed in a basic embodiment of a sampled data transmitting apparatus according to the present invention.

Figs. 3 and 4 show a concrete example of a recording format applied to a digital audio recording system, Fig. 3 showing a recording data structure for one block and Fig. 4 showing a block-complete type product code format.

Fig. 5 is a block diagram showing salient portions of an apparatus according to an embodiment of the present invention.

Fig. 6 is a block diagram showing an interleaving address generator.

Fig. 7 is a diagrammatic view for illustrating the operation of the interleaving address generator.

Fig. 2 shows a recording format employed in a sampled data transmission apparatus according to a basic embodiment of the present invention.

Referring to Fig. 2, sampled data from, for example, audio signals, are grouped into blocks each including a predetermined number of samples, and are arranged in a two-dimensional data array. The Q parity is annexed to each row by C2 coding, while the P parity is annexed to each column by C1 coding. The Q parity of each row is arrayed in the central region of the row and, in different column regions on the left and right sides of the Q parity region, even-numbered sample data $S_0$, $S_2$, ... and odd-numbered sample data $S_1$, $S_3$, ... are arrayed in segregation from one another. In order that the mutually adjoining sampled data are not positioned in the same row, the odd-numbered sample data $S_1$, $S_3$, ..., on the right side of the Q parity region, for example, are arrayed with interchanging of the row sequences for every other row. During signal transmission, such as during recording, sampled data are read out sequentially from the left-hand column of the two-dimensional data array, in the vertical direction as indicated by the arrow C, with the scanning in the vertical direction progressing column-wise towards the right sequentially.

In the illustrated example, the number of samples in each row of the two-dimensional data array in 50, and the 25 even-numbered data and 25 odd-numbered data samples are arrayed on the left-hand and right-hand sides of the Q parity region, respectively. The even-numbered sampled data $S_0$, $S_2$, ..., $S_{48}$ and the odd-numbered sampled data $S_{51}$, $S_{53}$, $S_{99}$, which are arrayed in the second row in the data array of Fig. 1, are arrayed in the first row R1, whereas the even-numbered sampled data $S_{50}$, $S_{52}$, ..., $S_{98}$ and the odd-numbered sampled data $S_1$, $S_3$, ..., $S_{49}$, which are arrayed in the first row in the data array of Fig. 1 are arrayed in the second row R2. In this manner, every other row is interchanged in the odd-numbered sampled data region.

With the above described data array, the even-numbered sampled data $S_0$, $S_2$, ..., $S_{48}$ and the odd-numbered sampled data $S_{51}$, $S_{53}$, ..., $S_{99}$, arrayed int he first row R1, for example, are not continuous or mutually adjacent data. Therefore, even if the number of sampled data that are in error in the first row R1 is increased beyond the error correction capability of the Q parity of the C2 system such that all of the data in the first row R1 are determined to be in error, the data in the next second row R2 are the continuous or mutually adjacent data with respect to these data in error, so that the errors occur at every other sample, or at a period of two samples, and hence may be effectively concealed by for example, mean value interpolation. In other words, the probability of feasible interpolation on the occurrence of uncorrectable error is increased, so reducing unwanted noise generation and improving the quality of the reproduced signals.

Figs. 3 and 4 illustrate a recording format which may be preferably employed in, for example, a professional digital audio recording system. Fig. 3 shows a recording data construction for one block and Fig. 4 shows a block-complete type product code format. In the present recording format, the frequency of a block and the frequency of a frame divided from a block are in integer ratios with respect to the corresponding frequencies of the so-called CD format now in widespread use, with a view to simplifying the interfacing structure with the structure of the clocking system for application to a CD mastering system.

Referring to Figs. 3 and 4, the sampled data to be transmitted are divided into blocks each consisting of a predetermined number of samples, with the block frequency being set so as to be in an integer ratio with respect to the block frequency of the CD format of 75 Hz, such as 25 Hz, which is one-third the CD format block frequency. Each block is constituted by a predetermined number of frames, with the frame frequency being set so as to be in an integer ratio with respect to the frame frequency for the CD format of 7.35 kHZ, for example 3.675 kHz, which is one half the frame frequency for the CD format. The number of frames in each block is one of the measures 252, 147, 98, ... of 44.1 kHz, which is the sampling frequency used for analog-to-digital conversion of the input audio signal. The number of frames is set to 147, for example. Thus the frame frequency may be found from the number of the frames of 147 and the block frequency of 75 Hz by the formula

$$25(\text{Hz}) \times 147 = 3.675(\text{kHz}).$$

On the other hand, the frequency of the clock components of the signals modulated for transmission or recording, or the so-called channel clock frequency, is set so as to be an integer multiple of, for example, 115 times, the above-mentioned sampling frequency, ie 5.0715 MHz. The number of bits per sample may be 16, 20 or 24. In the following example, the number of bits per sample is 16.

Referring to Fig. 3, a 2-frame edit gap EG, a 2-frame preamble PRA, a data frame constituted by 142 frames DF0, DF1, ..., DF141, and a 1-frame postample POA, are arrayed in this order from the leading end of a block consisting of 142 frames. Each of these frames is constituted by 79 bytes and 37 channel bits and has a two-dimensional data array in the form of a matrix as shown in Fig. 4. In this figure, the data frame is constituted, starting from the leading end of each frame, of a frame sync FS formed by 37 channel bits, a frame address FA formed by 1 byte, a frame address FA formed by 1 byte , a frame address parity FAP formed by 1 byte and a C1 code or P parity formed by 8 bytes.

It will be noted that, insofar as the 70-byte data portion and the 8-byte C1 code or P parity region are concerned, 16-bit samples of the left and right stereo channels in the 142-frame region of Fig. 4 are split with 8 bits or 1 byte as a unit, and the thus split samples (8-bit samples) are arranged so that even-numbered samples and odd-numbered samples are in different rows. In Fig. 4, $L_{0U}$, $L_{0L}$, $R_{0U}$ and $R_{0L}$ represent 8-bit or 1-byte data formed by splitting the 16-bit samples into upper 8 bits and lower 8 bits. For example, $L_{0U}$ and $L_{0L}$ represent the upper and lower 8 bits, respectively, of the leading one of 16-bit samples of the left channel are of the block.

In the concrete example of Fig. 4, the upper and lower 8 bits of the left channel 16-bit samples and the upper and lower 8 bits of the corresponding right channel 16-bit samples are continuously arranged in four rows of a column. For example, in first to fourth rows of the first column of Fig. 4, the above mentioned 8-bit samples $L_{0U}$, $L_{0L}$, $R_{0U}$ and $R_{0L}$ are arranged sequentially. With the four-row four-byte data as one unit, the even-numbered sample data and the odd-numbered sample data are arranged in different column region in the left side 67 frame region and right side 67-frame region. Thus even-numbered sample data are arranged in the left side 67 frames or 67 columns of the 142 frames or 142 columns making up the data frame of Fig. 4. The C2 code parity or Q parity is arranged in the central 8 frames or 8 columns. The odd-numbered sample data are arranged in the right side 67 frames or 67 columns of the 142 frames or columns.

In order to avoid the situation in which an entire row consists of contiguous or mutually adjoining samples, the odd-numbered samples in the right side 67-frame or 67-column region are arranged with row sequence interchanging with the four rows as one unit. That is, the four adjacent rows are interchanged as a whole with the four adjacent rows that are adjacent to the firstly mentioned four adjacent rows. This interchanging may also be performed on the even-numbered samples.

The construction of an apparatus for implementing the recording format described with reference to Fig. 2 is hereinafter explained.

Fig. 5 shows a data array controlling apparatus as a whole in a digital audio data transmission system according to the present invention. In this figure, digital audio data $S_0$, $S_1$, $S_2$, ..., $S_n$, sampled in this sequence, are input to a digital data interfacing circuit 1, and thence to an interleaving RAM 3 over data bus 2 after processing for bit reduction if required

Address data generated by an interleaving address generator 5 for causing the digital audio data $S_0$, $S_1$, $S_2$, ... $S_n$ to be written in accordance with the format described later is supplied by means of an address generator 4 to the interleaving RAM 3. This address selector 4 is controlled by selector control signals, supplied from a clock timing generator 10 over conductor C2 at the timing controlled by a microcomputer, not shown, to receive addresses generated by an interleaving address generator 5. The address selector is adapted to receive address data from a parity computing address generator 6 or a data outputting address generator 7. The digital audio sampled data $S_0$, $S_1$, $S_2$, ..., $S_n$ are sequentially stored at predetermined locations in RAM 3 in accordance with addresses generated by the interleaving address generator 5. Fig. 2 shows a map 20 for the interleaving RAM 3, as described above. In this figure, even-numbered data $S_0$, $S_2$, $S_4$, ..., $S_{2n}$ of the digital audio sampled data are stored in a storage area 1(21), odd-numbered data $S_1$, $S_3$, $S_5$, ..., $S_{2n+1}$ of the digital audio sampled data are stored in a storage area 323, parity data or Q parity data for the horizontal data are stored in a storage area 2(22) and parity data or P parity data for the vertical data are stored in a storage area 4 (24).

Referring to Fig. 2, on arrival of digital audio sampled data $S_0$ at RAM 3, an address data 0 is input to RAM 3 from the interleaving address generator 5 in order to cause the data $S_0$ to be stored at address 0 of the area 1(21) of RAM 3. This state is shown by 0/S0. The digital audio sample data S1 then is entered into RAM 3. At this time, the address data of the interleaving address generator 5 is 1551, so that the data S1 is stored in a first column of a second row of the area 3(23) of RAM 3, in order not to cause continuous or mutually adjoining samples to exist in the same row. This state is indicated by 1551/S1. When next the data S2 is input to RAM 3, an address data 50 is generated by the interleaving address generator 5. Similarly, when the data S3 is input to RAM, an address data 1601 is generated by the interleaving address generator 5. These data S2, S3 are stored in the second column of the first row of the area 1(21) and in the second column of the second row of the area 3 (23), respectively, as indicated by 50/S2 and 1601/S3, respectively. In the similar manner, the even-numbered data and the odd-numbered data of the audio sample data are sequentially stored in the area 1(21) and area 3(23), respectively. After the last digital audio sampled data $S_{1999}$ of the block is stored in the 25th column of the 44th row of the area 3(23), as indicated by 2793/$S_{1999}$, a control signal generated by clock timing generator 10 is supplied over conductor C2 to the address selector 4. This control signal causes the address selector 4 to be switched to the side of the parity computing address generator 6 for supplying the output address of the generator 6 to the interleaving RAM 3. Addressing by the parity computing address generator 6 causes the data 0/$S_0$, 50/$S_2$, ..., 1200/$S_{48}$, 1550/$S_{51}$, 1600/$S_{53}$, ... 2750/$S_{99}$ of the first row of the areas 1(21) and 3(23) of the interleaving RAM 3 to be read sequentially and supplied over data bus 2 to parity generator 8. The generator 8 performs various arithmetic operations on these data S0, S2, ..., S48, S51, S53, ..., S99 to generate six data $Q_{0.0}$, $Q_{0,1}$, $Q_{0,2}$, $Q_{0,3}$, $Q_{0,4}$ and $Q_{0,5}$. The data $Q_{0,0}$ may for example be the result of simple addition of the sample data S0, S2, ..., S51, S53, ..., S99, whereas the data $Q_{0,1}$ may be the result of multiplication of the sampled data by a first weighing coefficient. Similarly, the data $Q_{0,2}$, $Q_{0,3}$, $Q_{0,4}$ and $Q_{0,5}$ may be the result of multiplication of the sampled data by second, third, fourth and fifth coefficients followed by summation. After formation of these parity data $Q_{0,0}$, $Q_{0.1}$, $Q_{0,2}$, $Q_{0,3}$, $Q_{0,4}$ and $Q_{0,5}$, the parity generator 8 causes these parity data $Q_{0,0}$ to $Q_{0,5}$ to be supplied over data bus 2 to the interleaving RAM 3 by a control signal supplied from the clock timing generator 10 over conductor C4. On arrival of data $Q_{0,0}$ and $Q_{0,1}$, addresses 1250 and 1300 are designated in the interleaving RAM3, respectively, under control by the parity computing address generator 6, so that these parity data $Q_{0,0}$ to $Q_{0,5}$ are stored in the first row of the storage area 2(22) of Fig. 2 as 1250/$Q_{0,0}$, 1300/$Q_{0,1}$, ..., 1500/$Q_{0,5}$, respectively. In a similar manner, all of the parity data $Q_{1,0}$, $Q_{1,1}$, ..., $Q_{1,5}$, ..., $Q_{43,0}$, ... $Q_{43,5}$ are stored in the area 2 22 of Fig. 2. In this manner, the digital audio sample data consisting of the even-numbered sample data and the digital audio sample data consisting of odd-numbered sample data are stored in the areas 1 and 3, whereas the a parity data are stored in the area 2. The formation and storage of the Q parity data is then performed. That is, data 0, 1, 2, 3, ..., 43 are sequentially generated by the parity computing address generator 6 so that data $S_0$, $S_{50}$, $S_{100}$, ..., $S_{2100}$, $S_{2150}$, stored in these addresses, are supplied by the interleaving RAM 3 over data bus 2 to the parity generator 8. In this manner, 44 sample data in the first column of the area 1(21) of RAM 3 are first supplied to the parity generator 8. The generator 8 performs an arithmetic operation similar to the arithmetic operation of generating the Q parity data to generate six P parity data, that is $P_{0,0}$, $P_{0,0}$, $P_{0,1}$, $P_{0,2}$, $P_{0,3}$, $P_{0,4}$ and $P_{0,5}$ for the sample data $S_0$, $S_{50}$, ..., $S_{2150}$ in the first column of the area 1(21). These six P parity data $P_{0,0}$ to $P_{0,5}$ are supplied from parity generator 8 over data bus 2 to the interleaving RAM 3. Since the RAM 3 is controlled at this time by the parity computing address generator 6 so as to supply address 44, 45, ..., 49 to the P parity data $P_{0,1}$, $P_{0,2}$, ..., $P_{0,5}$ as shown in Fig. 2, the parity data are stored in the first column of the area 4(24) of Fig. 2, as indicated by 44/$P_{0,0}$, 45/$P_{0,1}$, ..., 49/$P_{0,5}$, respectively. Thus the area 4(24) is provided for storing the P parity data. In a similar manner, 44 sample data of the second column of area 1(21) are selected and transmitted to the parity generator 8 to generate six P parity data $P_{1,0}$, $P_{1,1}$, $P_{1,2}$, $P_{1,3}$, $P_{1,4}$ and $P_{1,5}$ which then are stored in the second column of the area 4(24), as indicated by 94/$P_{1,0}$, ... 99/$P_{1,5}$, by a process similar to that described in the foregoing. The P parity data up to $P_{55,0}$ ... $P_{55,5}$ are generated and stored in area 4(24), by a sequence of operations similar to that described in the foregoing to complete the 1block record data. After the data are stored in their entirety in accordance with the format shown in Fig. 2, the address selector 4 is switched from the side of the parity computing address generator 6 to the side of the data output address generator 7, under the command address information generated by the address output address generator 7 to the interleaving RAM 3. This switching sets the RAM 3 to the reading mode, while causing addresses 0 to 2799 to be sequentially designated in the RAM 3, so that the sampled data stored in RAM 3 are sequentially read from the first column to the 56th column of the RAM map shown in Fig. 2 and supplied to a modulator 9 over data bus 2.

The sample data are modulated in the modulator 9 into a data format suitable for recording so as to be supplied as recording signals to an output terminal 11. In the above description, after the P parity data $P_{0,0}$ to $P_{0,5}$ are formed, these data are returned from the parity generator 8 to RAM 3 over data bus 2 and, after the sample data are stored in their entirety in RAM 3, they are supplied over data bus 2 to modulator 9. However, this is not limitative and the P parity data $P_{0,0}$ to $P_{0,5}$, generated by the parity generator 8, may be directly transmitted from the parity generator 8 to the modulator 9 over data bus 2 along with the sample data $S_0$, $S_{50}$, ..., $S_{2150}$.

The operation of the interleaving address generator 5, the details of which are shown in Fig. 6, will be hereinafter explained with reference to Fig. 7. In Fig 6, the count value of a 1/50 word counter 31 counting word clocks is input to one input terminal of a multiplier 33, and a numerical value 50 is input to the other input terminal of the multiplier 33. Thus a value equal to 50 times the count value of the counter 31 is supplied to an output of the multiplier 33 and input to a first adder 34. If the above count value is indicated at B and the output value of the multiplier 33 is indicated at C, the values B and C are as indicated at B and C, respectively, in the time chart of Fig. 7. That is, since the word clocks input to the 1/50 counter 31 are at a frequency equal to the frequency of the input data $S_0$ to $S_n$ shown at the upper row in Fig. 7, and the above count value represents the output from MSB to LSB of the 1/50 counter, the count value is incremented by 1 at an interval of 2 word clocks, as shown at B in Fig. 7. Thus the count value is output with 0, 1, ..., 24, as one period and the output value C of the multiplier 33 is output with 0, 50, 100, ..., 1200, as one period, as shown at C in Fig. 7.

The word clocks are supplied, after frequency division by 1/50 in the word counter 31, to a row counter as clocks 32 over conductor 36. Thus the output signal G of the row counter 32 is incremented by 1 at an interval of 50 word clocks, as shown at G in Fig. 7. The LSB of the output signal G is supplied to an S input terminal of a data selector (1)35. When the LSB is 0, the output D of the data selector (1)35 is "+1" as shown at D in Fig. 7 and, when the LSB is 1, the output D of the data selector (1)35 is "-1". This output D is supplied to one input terminal of the adder 37, while the value 1550 is supplied to the other input terminal of the adder 37. Thus the value -1+1550 = 1549 or the value +1+1550 = 1551 is output from the adder 37 to the data selector (2)38 according as the value of the output D is -1 or +1, respectively. The value "0" is supplied to one input terminal of the data selector (2)38, respectively. The value "0" is supplied to one input terminal of the data selector 2(38) as shown in Fig. 6. The LSB data of the count value of the word counter 31 is supplied to the select terminal S of the data selector (2)38. The data selector(2)38 transmits the value "0" or the value "1549" or "1551" to the adder 34 as the data E when the LSB data is "0" or "1", respectively. Thus, as shown in Fig. 7D and 7E, the value of the data E becomes alternately "0" and "1551" when the data D is "+1", while becoming alternately "0" and "1549" when the data D is "-1". Since the output value F of the adder 34 is data C + data E, the data F is changed as shown in Fig. 7F. The data F and the data G are summed to each other at the adder 39. If the result of addition is expressed as data H, the state of change of the value of the data H is 0, 1551, 50, 1601, ..., 1200, 2751, as shown in Fig. 7H. Hence, if this value is used as the address, the continuous digital audio sample data $S_0$, $S_1$, $S_2$, $S_3$, ..., $S_{48}$, ... $S_{99}$ may be stored at addresses 0, 1551, 50, 1601 ..., 1200, ... 2751, respectively.

With the above described data array, any row is never filled with continuous or mutually adjacent samples, so that interpolation may be performed effectively even if all the words in a given row are determined to be in error.

In the above described arrangement, since the block frequency or the frame frequency of the digital audio recording format for professional applications are set so as to be at integer ratios with respect to the corresponding frequencies of the CD format, the construction of the clocking system and the interfacing system may be simplified in case of application of the CD mastering system.

The present invention is not limited to the above described embodiment. For example, if the number of bits of the sample data different from the number of bits of the word used as the units for error correction is employed, these numbers of bits may be set freely. In this case, the words making up each sample need not be arrayed vertically, as shown in Fig. 4, but may be arrayed horizontally. The number of interchanged rows may be set in any desired manner. If interchanging is made at an interval of plural rows, a so-called nesting technique may be employed in which the row array in the interchanging unit is changed, for example, the row sequence is rearranged within the 4-row unit of the even-numbered sample region shown in Fig. 4. In addition, the rows may be rearranged in both the even-numbered sample region and the odd-numbered sample region, provided that in the resulting rearrangement continuous sample data are not present in one and the same row as a result of rearrangement.

## Claims

1. An apparatus for transmitting two dimensional blocks of digital data along with error correction codes comprising

   means (3,4,5) for splitting a predetermined amount of digital data into odd-numbered data and even-numbered data and arranging the data into a block,
   means (6,8) responsive to a row of the block of said odd-numbered data and said even-numbered data to generate first parity codes and to arrange said first parity codes in the respective row, said means being also responsive to a column of said block of said odd-numbered data and said even-numbered data to generate second parity codes and to arrange said second parity codes in the respective column, and
supplying means (7) for columnwise supplying said digital data and said first and second parity codes in the order of column numbers, characterised in that
said splitting means (3,4,5) includes addressing means for arranging data to be in one row of said block and for arranging substantially all of the data originally adjacent said data of said one row to be in another row of said block so that the even-numbered and odd-numbered data which were adjacent one another in the original digital signal are arranged in separate rows of said block.

**2.** An apparatus according to claim 1 comprising

an interleaving memory (3) for storing the digital data and the parity codes; and wherein
said splitting means comprises an interleaving address generating means (4) for controlling digital data writing addresses to said interleaving memory (3) for causing the row arraying for the odd-numbered rows to differ from the row arraying for the even-numbered rows so that originally adjacent odd-numbered data and even-numbered data are arranged in different rows of a two-dimensional data array so that successive odd-numbered and even-numbered data are not arranged in one row, and
the supplying means comprises means (7) for generating addresses for reading out the digital data and the parity codes written in said interleaving memory (3).

**3.** An apparatus according to claim 2 wherein the digital data comprise sample data and the parity codes comprise error correcting data.

**4.** An apparatus according to claim 1, 2 or 3 and including means operative on de-interleaving of the arrayed data, on detection of an uncorrectable data item, to interpolate a replacement therefor from adjacent correct sample data.

**Patentansprüche**

**1.** Gerät zum Übertragen zweidimensionaler Blöcke von digitalen Daten zusammen mit Fehlerkorrekturcodes, das umfaßt:

ein Mittel (3, 4, 5) zum Zerlegen einer vorbestimmten Menge digitaler Daten in ungeradzahlige Daten and geradzahlige Daten und Anordnen der Daten zu einem Block,
ein Mittel (6, 8), das auf eine Zeile des Blocks aus den ungeradzahligen Daten und den geradzahligen Daten anspricht, um erste Paritätscodes zu erzeugen und um die ersten Paritätscodes in der betreffenden Zeile anzuordnen, wobei das Mittel außerdem auf eine Spalte des Blocks aus den ungeradzahligen Daten und den geradzahligen Daten anspricht, um zweite Paritätscodes zu erzeugen und um die zweiten Paritätscodes in der betreffenden Spalte anzuordnen, und
ein Ausgabemittel (7) zum spaltenweisen Liefern der digitalen Daten und der ersten und zweiten Paritätscodes in der Reihenfolge der Spaltennummern,
dadurch **gekennzeichnet** , daß
das Mittel (3, 4, 5) zum Zerlegen ein Adressierungsmittel enthält zum Anordnen von Daten, die in einer Zeile des Blocks enthalten sein sollen, und zum Anordnen von im wesentlichen aller der ursprünglich den Daten der einen Zeile benachbarten Daten, die in einer weiteren Zeile des Blocks enthalten sein sollen, so daß die geradzahligen und ungeradzahlige Daten, die einander in dem ursprünglichen digitalen Signal benachbart waren, in getrennten Zeilen des Blocks angeordnet werden.

**2.** Gerät nach Anspruch 1, das

einen Verschachtelungsspeicher (3) zum Speichern der digitalen Daten und der Paritätscodes umfaßt und bei dem
das Mittel zum Zerlegen ein VerschachtelungsadressenErzeugungsmittel (4) zum Steuern des Zuführens von Digitaldaten-Schreibadressen zu dem Verschachtelungsspeicher (3) enthält, um zu veranlassen, daß sich die Zeilenanordnung für die ungeradzahligen Zeilen von der Zeilenanordnung für die geradzahligen Zeilen derart unterscheidet, daß die ursprünglich benachbarten ungeradzahligen Daten und geradzahligen Daten in unterschiedlichen Zeilen eines zweidimensionalen Datenfelds angeordnet werden, so daß aufeinanderfolgende ungeradzahlige and geradzahlige Daten nicht in einer Zeile angeordnet sind, und
das Ausgabemittel ein Mittel (7) zum Erzeugen von Adressen zum Auslesen der digitalen Daten und der Paritätscodes, die in den Verschachtelungsspeicher (3) eingeschrieben sind, enthält.

**3.** Gerät nach Anspruch 2, wobei die digitalen Daten Abtastdaten und die Paritätscodes Fehlerkorrekturdaten enthalten.

**4.** Gerät nach Anspruch 1, 2 oder 3, das Mittel enthält, die beim Entschachteln der angeordneten Daten auf die Erfassung eines nichtkorrigierbaren Datenworts hin wirksam sind, um dafür durch Interpolation einen Ersatz aus benachbarten korrekten Abtastdaten zu erzeugen.

**Revendications**

**1.** Dispositif pour transmettre des blocs bidimensionnels de données numériques avec des codes de correction d'erreur, comprenant:

- des moyens (3, 4, 5) pour diviser une quantité prédéterminée de données numériques en données impaires et données paires et disposer les données en un bloc;
- des moyens (6, 8) sensibles à une ligne du bloc desdites données impaires et desdites données paires pour produire des premiers codes de parité et pour disposer lesdits premiers codes de parité dans la ligne respective, lesdits moyens étant également sensibles à une colonne dudit bloc desdites données impaires et desdites données paires pour produire des deuxièmes codes de parité et pour disposer lesdits deuxièmes codes de parité dans la colonne respective; et
- des moyens de fourniture (7) pour fournir, colonne par colonne, lesdites données numériques et lesdits premiers et deuxièmes codes de parité dans l'ordre des numéros de colonnes, caractérisé en ce que:
- lesdits moyens de division (3, 4, 5) comprennent des moyens d'adressage pour ordonner les données destinées à être dans une ligne dudit bloc et pour ordonner sensiblement toutes les données initialement adjacentes desdites données de ladite une ligne pour qu'elles soient dans une autre ligne dudit bloc, de manière que les données paires et impaires qui étaient adjacentes les unes aux autres dans le signal numérique initial soient disposées dans des lignes distinctes dudit bloc.

**2.** Dispositif selon la revendication 1, comprenant:

- une mémoire à entrelacement (3) pour mémoriser les données numériques et les codes de parité; et dans lequel
- lesdits moyens de division comprennent des moyens générateurs d'adresses à entrelacement (4) pour commander les adresses d'écriture des données numériques dans ladite mémoire à entrelacement (3) pour amener la disposition des lignes impaires à différer de la disposition des lignes paires de telle manière que les données impaires et les données paires initialement adjacentes soient disposées dans des lignes différentes d'un groupement bidimensionnel de données, de manière que des données paires et impaires successives ne soient pas disposées dans une même ligne; et
- les moyens de fourniture comprennent des moyens (7) pour produire des adresses pour lire les données numériques et les codes de parité écrits dans ladite mémoire à entrelacement (3).

**3.** Dispositif selon la revendication 2, dans lequel les données numériques sont des données échantillonnées et les codes de parité sont des codes de correction d'erreurs.

**4.** Dispositif selon la revendication 1, 2 ou 3, comprenant des moyens fonctionnant lors du désentrelacement des données disposées en groupement pour, lors de la détection d'un élément de donnée non corrigible, interpoler un remplacement pour celui-ci à partir de données échantillonnées correctes adjacentes.

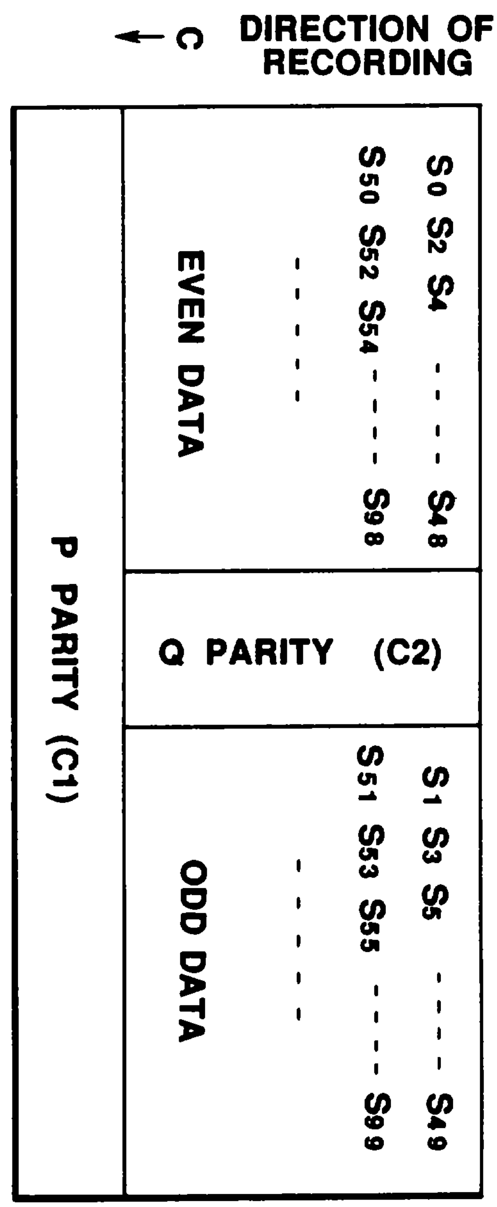
DIRECTION OF RECORDING
C
S0 S2 S4 - - - - S48
S50 S52 S54 - - - - S98
EVEN DATA
Q PARITY (C2)
S1 S3 S5 - - - - S49
S51 S53 S55 - - - - S99
ODD DATA
P PARITY (C1)

FIG.1

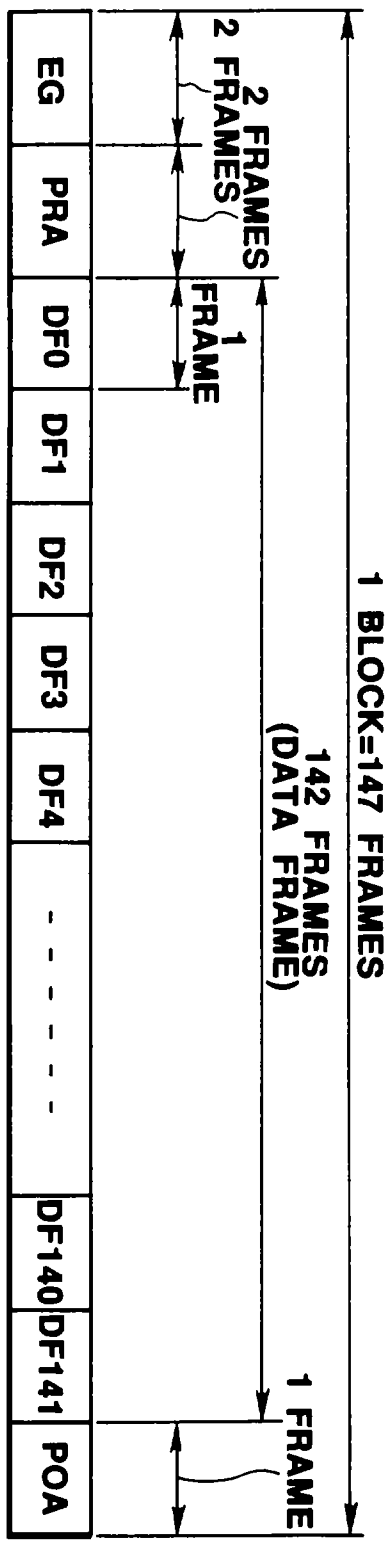
1 BLOCK=147 FRAMES
142 FRAMES (DATA FRAME)
2 FRAMES
2 FRAMES
1 FRAME
1 FRAME
EG
PRA
DF0
DF1
DF2
DF3
DF4
DF140
DF141
POA

FIG.3

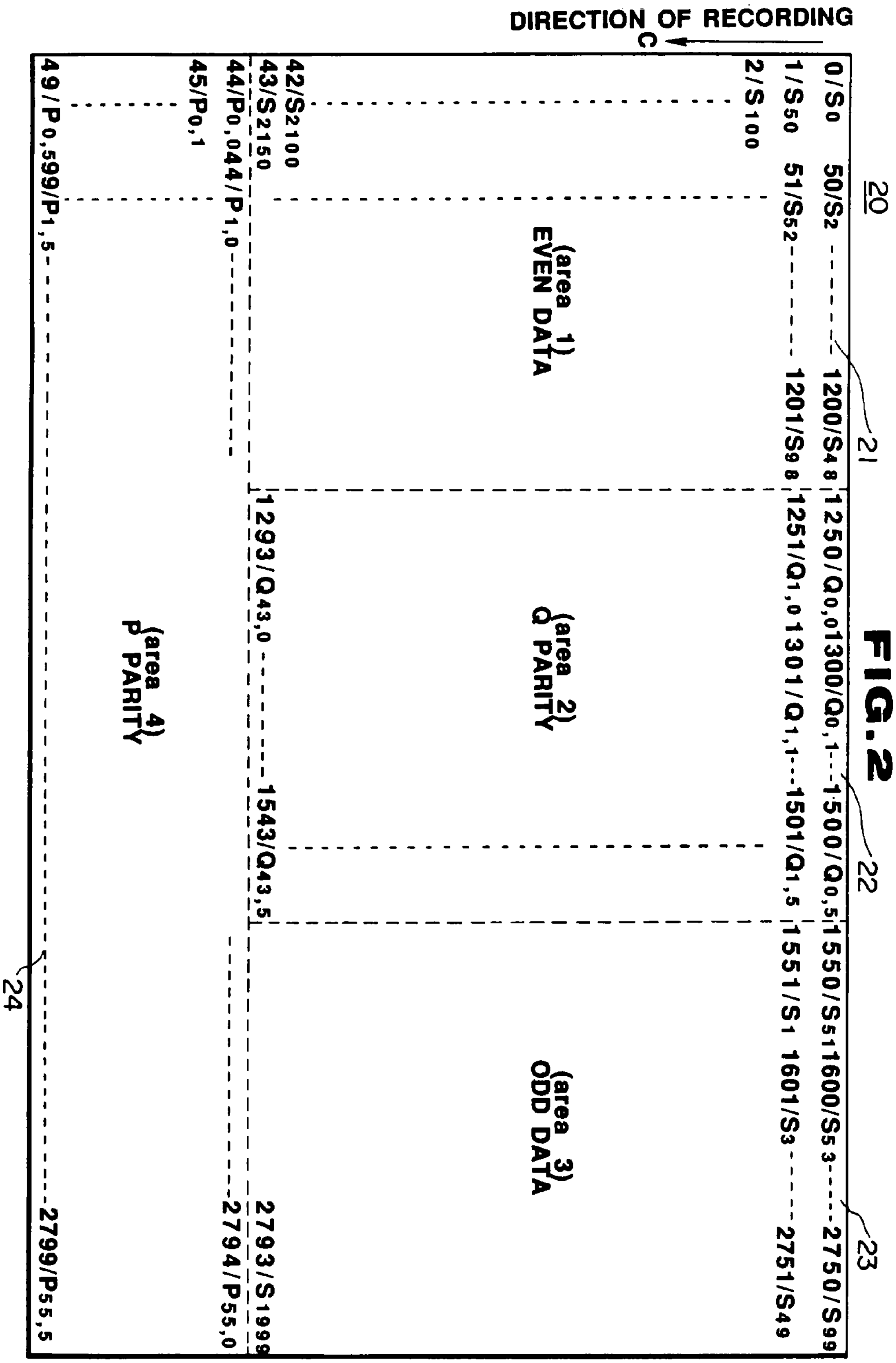
DIRECTION OF RECORDING
C
20
21
22
23
24
0/S0
1/S50
2/S100
50/S2
51/S52
1200/S48
1201/S98
1250/Q0,0
1251/Q1,0
1300/Q0,1
1301/Q1,1
1500/Q0,5
1501/Q1,5
1550/S51
1551/S1
1600/S53
1601/S3
2750/S99
2751/S49
42/S2100
43/S2150
44/P0,0
44/P1,0
45/P0,1
49/P0,5
99/P1,5
1293/Q43,0
1543/Q43,5
2793/S1999
2794/P55,0
2799/P55,5
(area 1)
EVEN DATA
(area 2)
Q PARITY
(area 3)
ODD DATA
(area 4)
P PARITY

FIG. 2

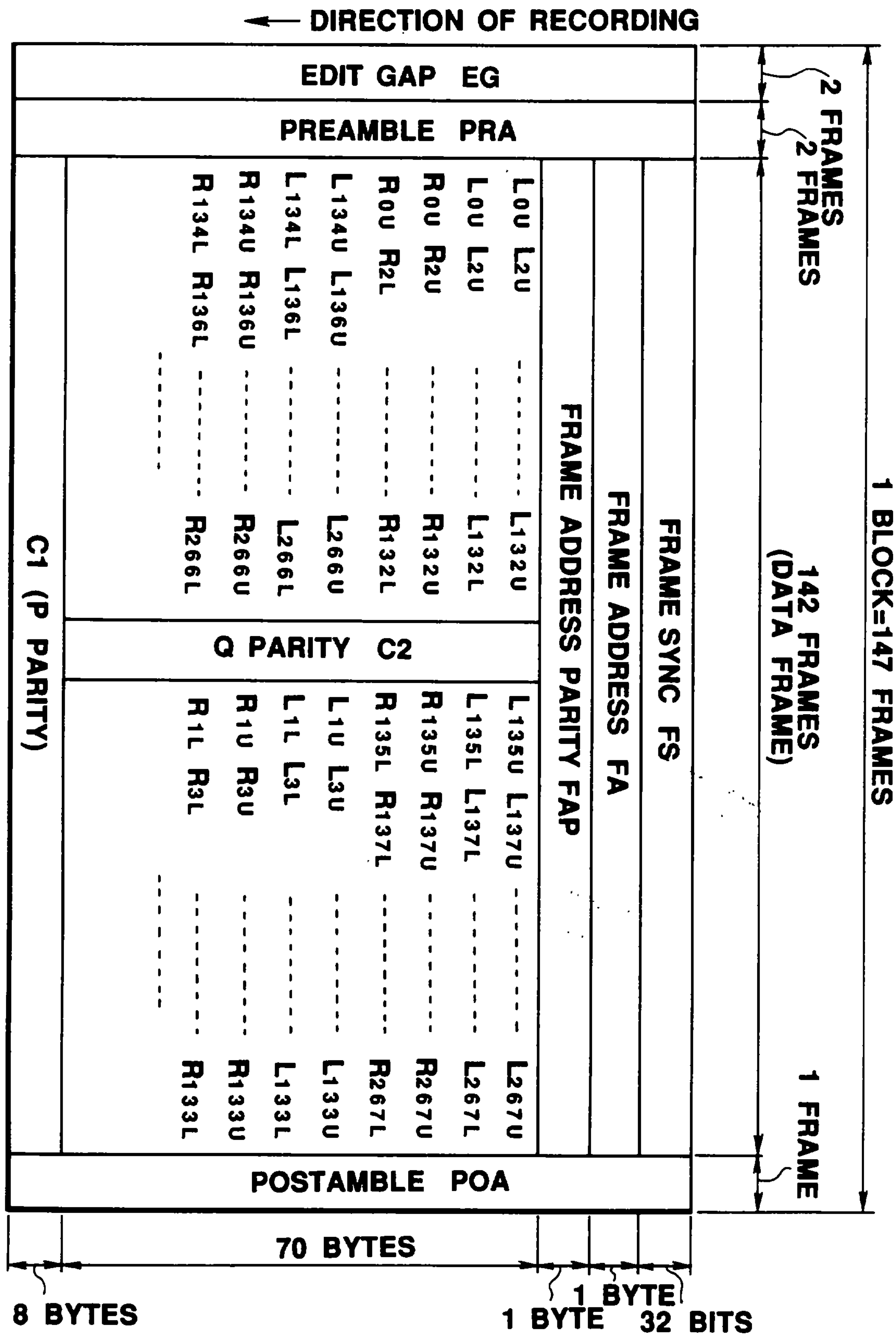
DIRECTION OF RECORDING
EDIT GAP EG
PREAMBLE PRA
L0U L2U ---------- L132U
L0U L2U ---------- L132L
R0U R2U ---------- R132U
R0U R2L ---------- R132L
L134U L136U ---------- L266U
L134L L136L ---------- L266L
R134U R136U ---------- R266U
R134L R136L ---------- R266L
Q PARITY C2
L135U L137U ---------- L267U
L135L L137L ---------- L267L
R135U R137U ---------- R267U
R135L R137L ---------- R267L
L1U L3U ---------- L133U
L1L L3L ---------- L133L
R1U R3U ---------- R133U
R1L R3L ---------- R133L
C1 (P PARITY)
FRAME ADDRESS PARITY FAP
FRAME ADDRESS FA
FRAME SYNC FS
POSTAMBLE POA
2 FRAMES
2 FRAMES
142 FRAMES (DATA FRAME)
1 FRAME
1 BLOCK=147 FRAMES
70 BYTES
8 BYTES
1 BYTE
1 BYTE
32 BITS

FIG. 4

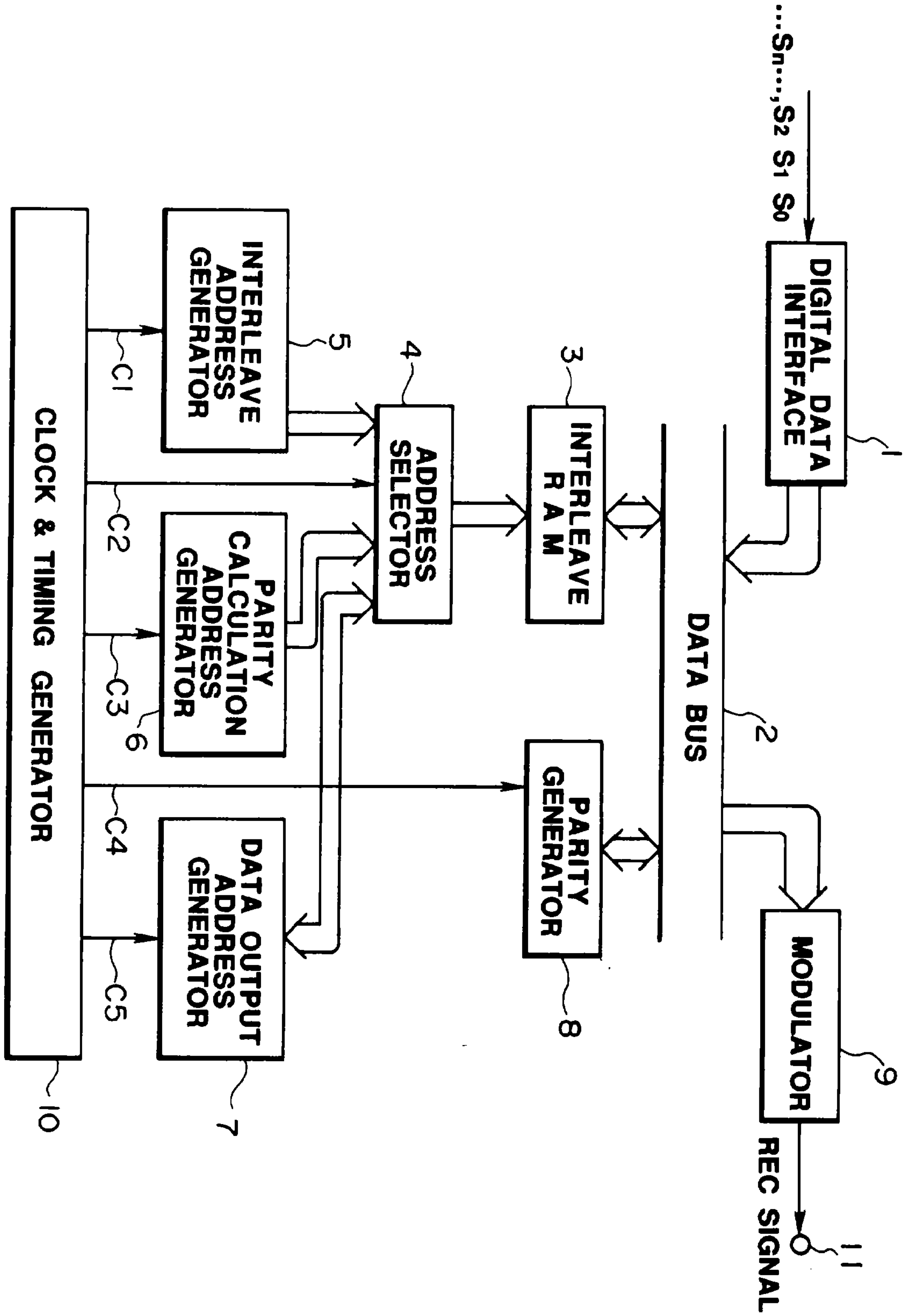
...Sn...,S2 S1 S0
DIGITAL DATA INTERFACE
1
DATA BUS
2
INTERLEAVE R A M
3
ADDRESS SELECTOR
4
INTERLEAVE ADDRESS GENERATOR
5
PARITY CALCULATION ADDRESS GENERATOR
6
DATA OUTPUT ADDRESS GENERATOR
7
PARITY GENERATOR
8
MODULATOR
9
REC SIGNAL
11
CLOCK & TIMING GENERATOR
10
C1
C2
C3
C4
C5

FIG.5

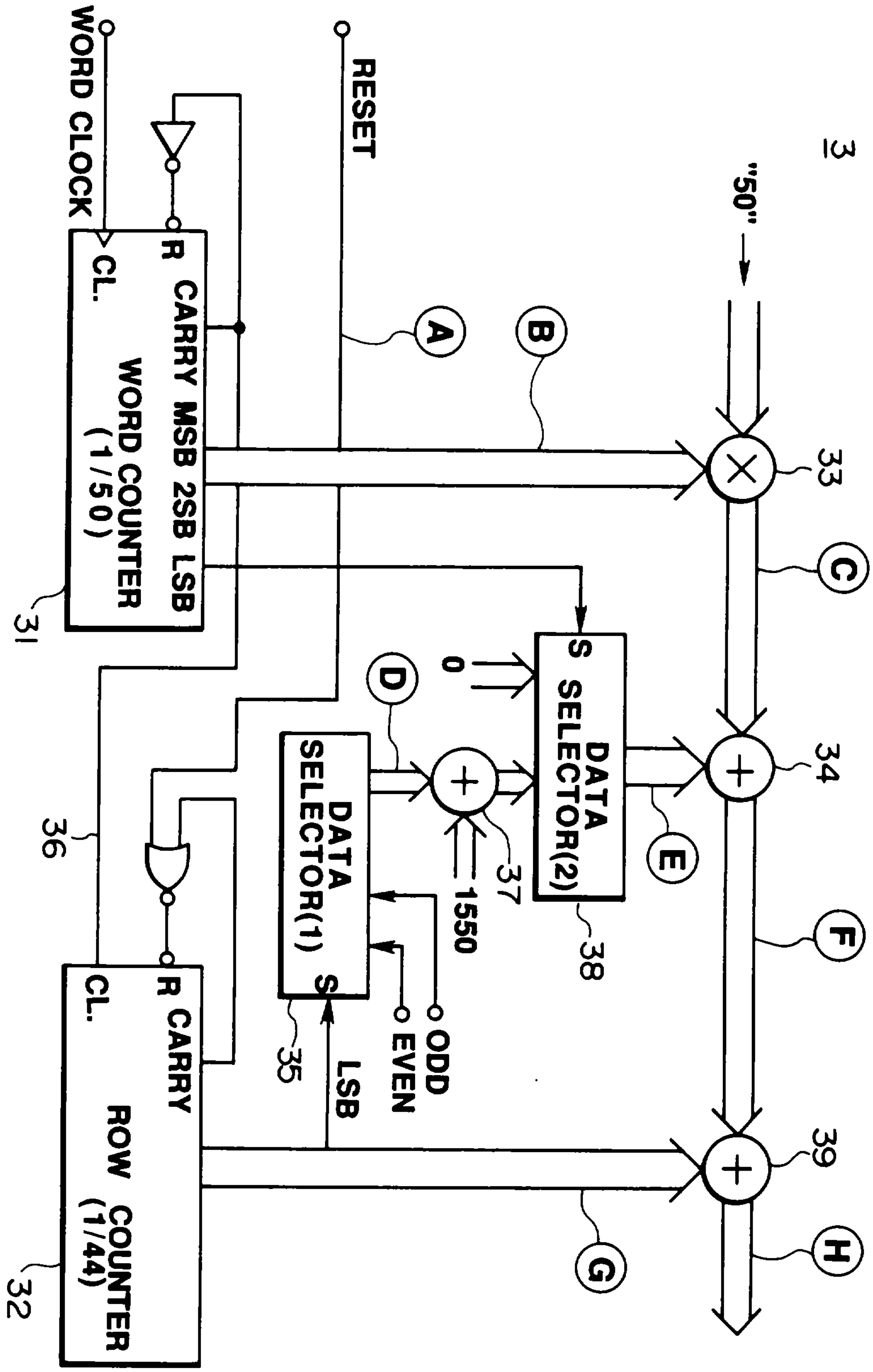
3
"50"
RESET
WORD CLOCK
R
CL.
CARRY MSB 2SB LSB
WORD COUNTER
(1/50)
31
A
B
33
C
S
0
DATA
SELECTOR(2)
38
D
37
1550
34
E
F
DATA
SELECTOR(1)
S
35
ODD
EVEN
LSB
36
R CARRY
CL.
ROW COUNTER
(1/44)
32
39
G
H

FIG.6

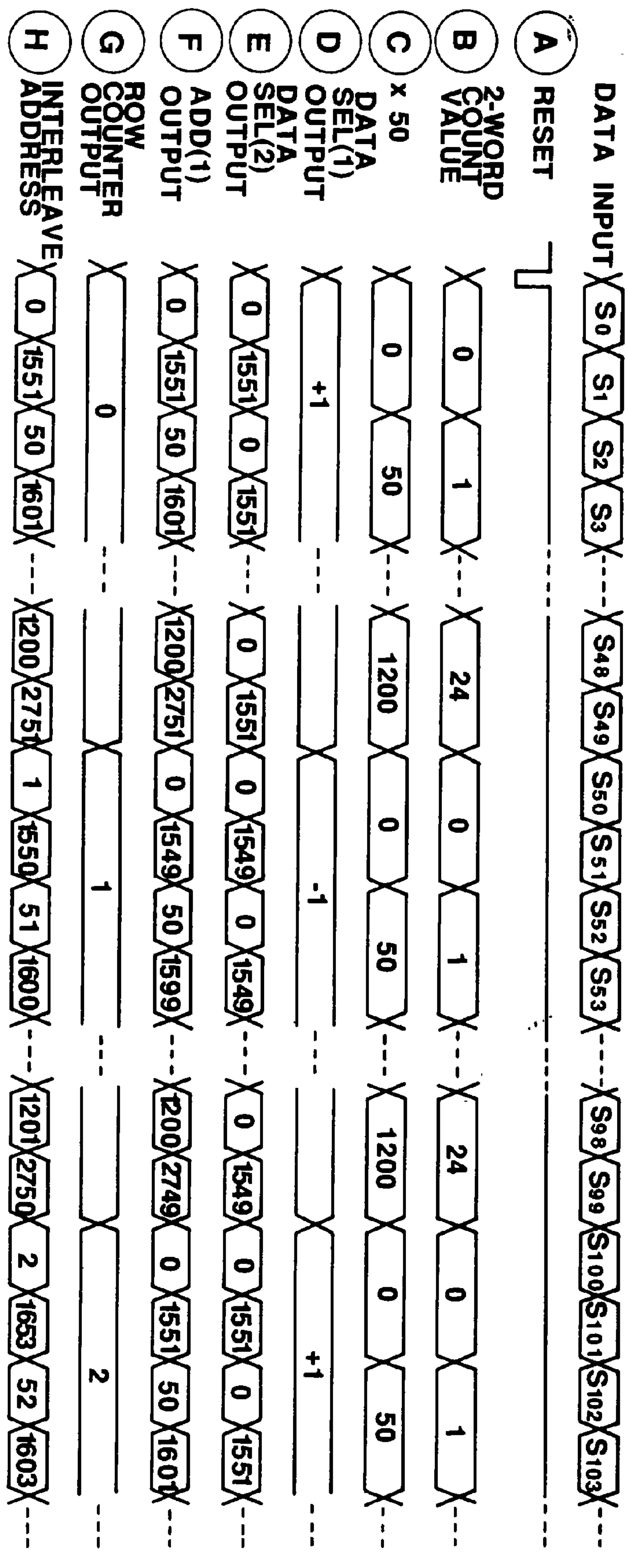

DATA INPUT
S0 S1 S2 S3 S48 S49 S50 S51 S52 S53 S98 S99 S100 S101 S102 S103
A RESET
B 2-WORD COUNT VALUE
0 1 24 0 1 24 0 1
C x 50
0 50 1200 0 50 1200 0 50
D DATA SEL(1) OUTPUT
+1 -1 +1
E DATA SEL(2) OUTPUT
0 1551 0 1551 0 1551 0 1549 0 1549 0 1549 0 1551 0 1551
F ADD(1) OUTPUT
0 1551 50 1601 1200 2751 0 1549 50 1599 1200 2749 0 1551 50 1601
G ROW COUNTER OUTPUT
0 1 2
H INTERLEAVE ADDRESS
0 1551 50 1601 1200 2751 1 1550 51 1600 1201 2750 2 1653 52 1603


FIG.7